# EUROPEAN PATENT SPECIFICATION

(11) **EP 4 322 161 B1**
(45) Date of publication and mention of the grant of the patent: **04.11.2026**
(21) Application number: 23217545.5
(22) Date of filing: 12.03.2012
(51) Int. Cl.: G10L 19/02, G10L 19/00, G10L 19/032

(54) **DEVICE AND METHOD FOR EXECUTION OF HUFFMAN CODING**
VORRICHTUNG UND VERFAHREN ZUR HUFFMAN-KODIERUNG
DISPOSITIF ET PROCÉDÉ D'EXÉCUTION DE CODAGE DE HUFFMAN

(30) Priority: 20.04.2011 JP 2011094295; 15.06.2011 JP 2011133432
(43) Date of publication of application: 14.02.2024
(62) Document number(s) of the earlier application(s) in accordance with Art. 76 EPC: 19194667.2 / 3 594 943; 16175414.8 / 3 096 315; 12774449.8 / 2 701 144
(73) Proprietor: Panasonic Holdings Corporation, Osaka 571-8501 (JP)
(72) Inventor: LIU, Zongxian, 469332 Singapore (SG); CHONG, Kok Seng, 469332 Singapore (SG); OSHIKIRI, Masahiro, Osaka 571-0057 (JP)
(74) Representative: Grünecker Patent- und Rechtsanwälte PartG mbB

(56) References cited:
- US-A1- 2008 252 510
- US-A1- 2009 030 678

## Description

### Technical Field

The present invention relates to an audio/speech encoding apparatus and audio/speech encoding method using Huffman coding.

### Background Art

In signal compression, Huffman coding is widely used to encode an input signal utilizing a variable-length (VL) code table (Huffman table). Huffman coding is more efficient than fixed-length (FL) coding for the input signal which has a statistical distribution that is not uniform.

In Huffman coding, the Huffman table is derived in a particular way based on the estimated probability of occurrence for each possible value of the input signal. During encoding, each input signal value is mapped to a particular variable length code in the Huffman table.

By encoding signal values that are statistically more likely to occur using relatively short VL codes (using relatively few bits), and conversely encoding signal values that are statistically infrequently to occur using relatively long VL codes (using relatively more bits), the total number of bits used to encode the input signal can be reduced.
US 2009/030678 A1 relates to binary coding of a signal envelope, comprising coding module for coding a variable length first mode. The coding module for coding the first mode incorporates an envelope saturation detector and said coding module further includes a second coding module for coding a second mode in parallel with the coding module for coding the first mode and a mode selector adapted to select one of the two coding modes as a function of a code length criterion and of the result from the envelope saturation detector.
US 2008/0252510 A1 relates to encoding spatial parameters (such as channel level difference - CLD) between multiple audio channels, quantizing them, and applying differential encoding to enhance efficiency. This method reduces bitrate by using location-specific quantization tables and optimizing the representation of spatial audio parameters.

### Citation List

[Non-patent document 1] ITU-T Recommendation G.719 (06/2008) "Low-complexity, full-band audio coding for high-quality, conversational applications"

### Summary of Invention

### Technical Problem

The invention is defined by the features of the independent claims. Any reference to inventions or embodiments not falling within the scope of the independent claims are to be interpreted as examples useful for understanding the invention.

However, in some applications, such as audio signal encoding, the signal statistics may vary significantly from one set of audio signal to another set of audio signal. And even within the same set of audio signal.

If the statistics of the audio signal varies drastically from the statistics of the predefined Huffman table, the encoding of the signal can not be optimally done. And it happens that, to encode the audio signal which has different statistics, the bits consumption by Huffman coding is much more than the bits consumption by fixed length coding.

One possible solution is to include both the Huffman coding and fixed length coding in the encoding, and the encoding method which consumes fewer bits are selected. One flag signal is transmitted to decoder side to indicate which coding method is selected in encoder. This solution is utilized in a newly standardized ITU-T speech codec G719.

The solution solves the problem for some very extreme sequences in which the Huffman coding consumes more bits than the fixed length coding. But for other input signals which have different statistics from the Huffman table but still select the Huffman coding, it is still not optimal.

In ITU-T standardized speech codec G719, Huffman coding is used in encoding of the norm factors' quantization indices.

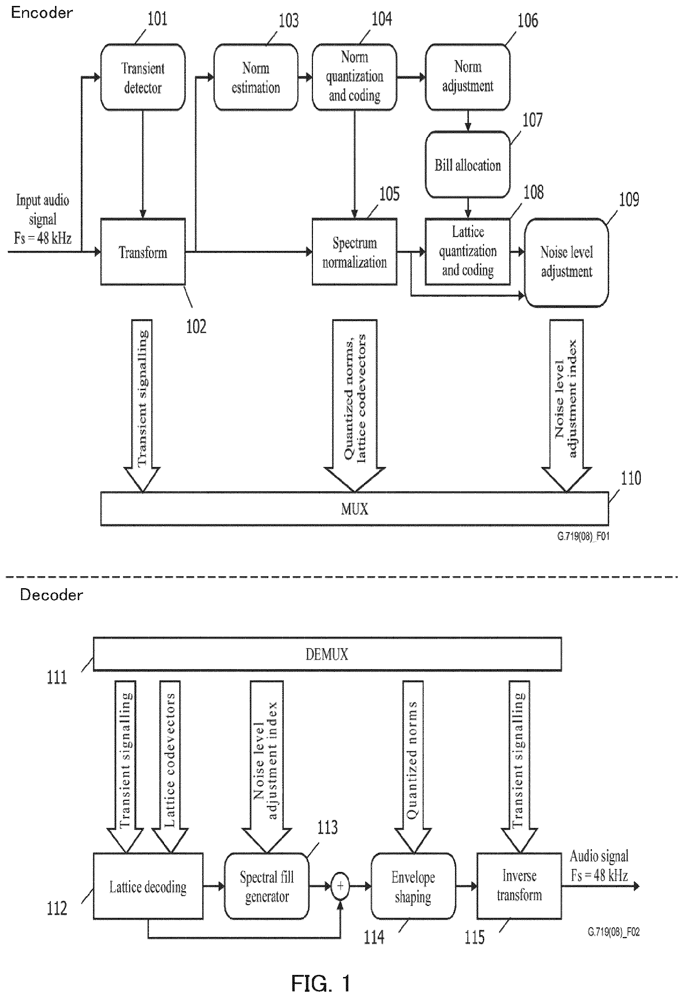

The structure of G.719 is illustrated in Figure 1.

At encoder side, the input signal sampled at 48 kHz is processed through a transient detector (101). Depending on the detection of a transient, a high frequency resolution or a low frequency resolution transform (102) is applied on the input signal frame. The obtained spectral coefficients are grouped into bands of unequal lengths. The norm of each band is estimated (103) and resulting spectral envelope consisting of the norms of all bands is quantized and encoded (104). The coefficients are then normalized by the quantized norms (105). The quantized norms are further adjusted (106) based on adaptive spectral weighting and used as input for bit allocation (107). The normalized spectral coefficients are lattice-vector quantized and encoded (108) based on the allocated bits for each frequency band. The level of the non-coded spectral coefficients is estimated, coded (109) and transmitted to the decoder. Huffman encoding is applied to quantization indices for both the coded spectral coefficients as well as the encoded norms.

At decoder side, the transient flag is first decoded which indicates the frame configuration, i. e., stationary or transient. The spectral envelope is decoded and the same, bit-exact, norm adjustments and bit-allocation algorithms are used at the decoder to recompute the bit-allocation which is essential for decoding quantization indices of the normalized transform coefficients. After de-quantization (112), low frequency non-coded spectral coefficients (allocated zero bits) are regenerated by using a spectral-fill codebook built from the received spectral coefficients (spectral coefficients with non-zero bit allocation) (113). Noise level adjustment index is used to adjust the level of the regenerated coefficients. High frequency non-coded spectral coefficients are regenerated using bandwidth extension. The decoded spectral coefficients and regenerated spectral coefficients are mixed and lead to normalized spectrum. The decoded spectral envelope is applied leading to the decoded full-band spectrum (114). Finally, the inverse transform (115) is applied to recover the time-domain decoded signal. This is performed by applying either the inverse modified discrete cosine transform for stationary modes, or the inverse of the higher temporal resolution transform for transient mode.

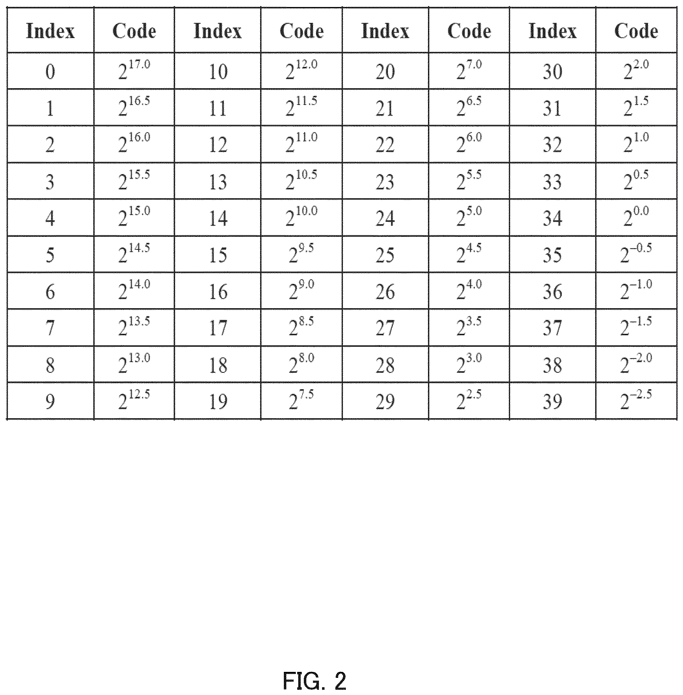

In encoder (104), the norm factors of the spectral sub bands are scalar quantized with a uniform logarithmic scalar quantizer with 40 steps of 3dB.The codebook entries of the logarithmic quantizer are shown in Figure 2. As seen in the codebook, the range of the norm factors is [2^{-2.5},2¹⁷], and the value decreases as the index increases.

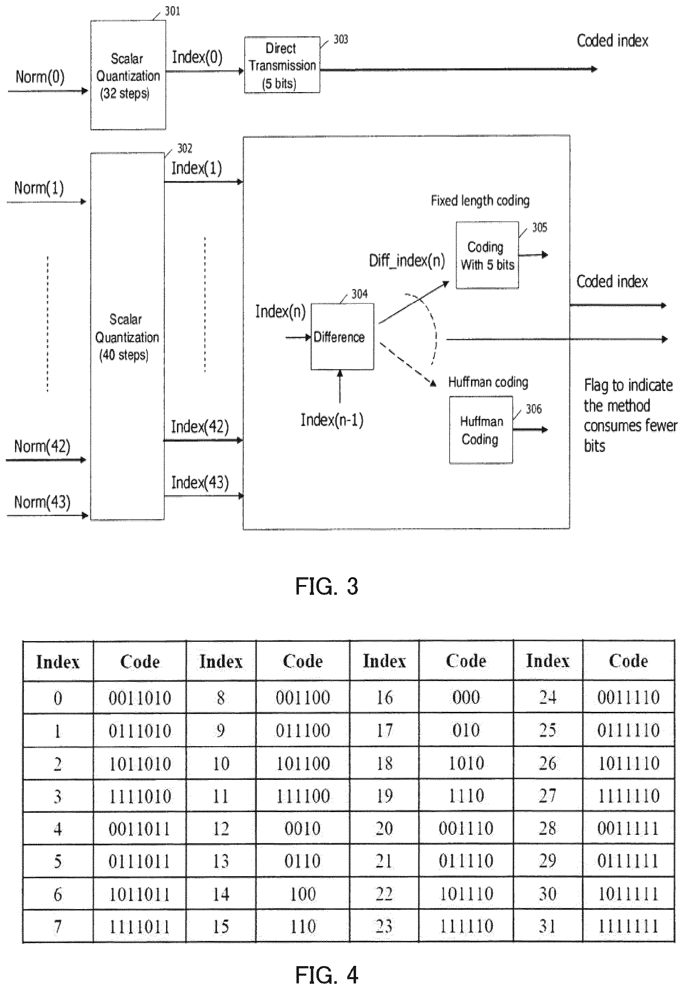

The encoding of quantization indices for norm factors is illustrated in Figure 3. There are in total 44 sub bands and correspondingly, 44 norm factors. For the first sub band, the norm factor is quantized using the first 32 codebook entries (301), while other norm factors are scalar quantized with the 40 codebook entries (302) shown in Figure 2. The quantization index for the first sub band norm factor is directly encoded with 5 bits (303), while the indices for other sub bands are encoded by differential coding. The differential indices are derived using the formula as following (304):
[1] $Diff _ index \left(n\right) = Index \left(n\right) - Index \left(n-1\right) + 15 for n ∈ \left[1, 43\right]$ (Equation 1)

And the differential indices are encoded by two possible methods, fixed length coding (305) and Huffman coding (306). The Huffman table for the differential indices is shown in Figure 4. In this table, there are in total 32 entries, from 0 to 31, which caters for possibilities of abrupt energy change between neighboring sub bands.

However, for an audio input signal, there is a physical phenomenon named as auditory masking. Auditory masking occurs when the perception of one sound is affected by the presence of another sound. As example, if there are two signals with similar frequencies existing at the same time: one powerful spike at 1kHz and one lower-level tone at 1.1kHz, the lower-level tone at 1.1kHz will be masked (inaudible) due to existence of the powerful spike at 1kHz.

The sound pressure level needed to make the sound perceptible in the presence of another sound (masker), is defined as masking threshold in audio encoding. The masking threshold depends upon the frequency, the sound pressure level of the masker. If the two sounds have similar frequency, the masking effect is large, and the masking threshold is also large. If the masker has large sound pressure level, it has strong masking effect on the other sound, and the masking threshold is also large.

According to the auditory masking theory above, if one sub band has very large energy, it would have large masking effect on other sub bands, especially on its neighboring sub bands. Then the masking threshold for other sub bands, especially the neighboring sub band, is large.

If the sound component in the neighboring sub band has small quantization errors (less than the masking threshold), the degradation on sound component in this sub band is not able to be perceived by the listeners.

It is not necessary to encode the normal factor with very high resolution for this sub band as long as the quantization errors below the masked threshold.

### Solution to Problem

The invention is defined by the features of the independent claims. Any reference to inventions or embodiments not falling within the scope of the independent claims are to be interpreted as examples useful for understanding the invention.

In this invention, apparatus and methods exploring audio signal properties for generating Huffman tables and for selecting Huffman tables from a set of predefined tables during audio signal encoding are provided.

Briefly, the auditory masking properties are explored to narrow down the range of the differential indices, so that a Huffman table which have fewer code words can be designed and used for encoding. As the Huffman table has fewer code words, it is possible to design the code codes with shorter length (consumes fewer bits). By doing this, the total bits consumption to encode the differential indices can be reduced.

### Advantageous Effects of Invention

By adopting Huffman codes which consume fewer bits, the total bits consumption to encode the differential indices can be reduced.

### Brief Description of Drawings

Figure 1 illustrates the framework of ITU-T G.719;
Figure 2 shows the codebook for norm factors quantization;
Figure 3 illustrates the process of norm factors quantization and coding;
Figure 4 shows the Huffman table used for norm factors indices encoding;
Figure 5 shows the framework which adopts this invention;
Figures 6A and 6B show examples of predefined Huffman tables;
Figure 7 illustrates the derivation of the masking curve;
Figure 8 illustrates how the range of the differential indices be narrowed down;
Figure 9 shows a flowchart of how the modification of the indices is done;
Figure 10 illustrates how the Huffman tables can be designed;
Figure 11 illustrates the framework of embodiment 2 of this invention;
Figure 12 illustrates the framework of embodiment 3 of this invention;
Figure 13 illustrates the encoder of embodiment 4 of this invention;
Figure 14 illustrates the decoder of embodiment 4 of this invention.

### Description of Embodiments

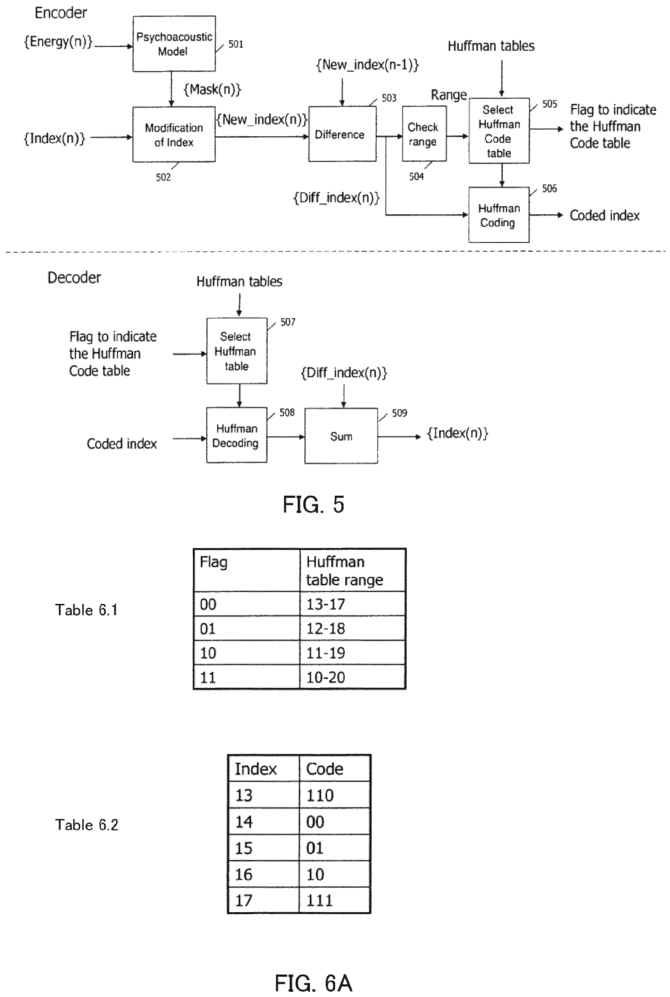

The main principle of the invention is described in this section with the aid of Figure 5 to Figure 12.
Illustrations are provided to facilitate explanation.

### (Embodiment 1)

Figure 5 illustrates the invented codec, which comprises an encoder and a decoder that apply the invented scheme on Huffman coding.

In the encoder illustrated in Figure 5, the energies of the sub bands are processed by the psychoacoustic modelling (501) to derive the masking threshold Mask(n). According to the derived Mask(n), the quantization indices of the norm factors for the sub bands whose quantization errors are below the masking threshold are modified (502) so that the range of the differential indices can be smaller.

The differential indices for the modified indices are calculated according to the equation below:
$\begin{matrix}Diff _ index \left(n\right) = New _ index \left(n\right) - New _ index \left(n-1\right) + 15 \\ for n ∈ \left[1, 43\right]\end{matrix}$ (Equation 2) The range of the differential indices for Huffman coding is identified as shown in the equation below (504).$Range = \left[Min\left(Diff_index\left(n\right),Max\left(Diff_index\left(n\right.\right)\right)\right]$ (Equation 3)

According to the value of the range, the Huffman table which is designed for the specific range among a set of predefined Huffman table is selected (505) for encoding of the differential indices (506). As example, if among all the differential indices for the input frame, the minimum value is 12, and the maximum value is 18, then the Range = [12,18]. The Huffman table designed for [12,18] are selected as the Huffman table for encoding.

The set of predefined Huffman tables are designed (detail will be explained in later part) and arranged according to the range of the differential indices. The flag signal to indicate the selected Huffman table and the coded indices are transmitted to the decoder side.

Another method for selection of Huffman table is to calculate all the bits consumption using every Huffman table, then select the Huffman table which consumes fewest bits.

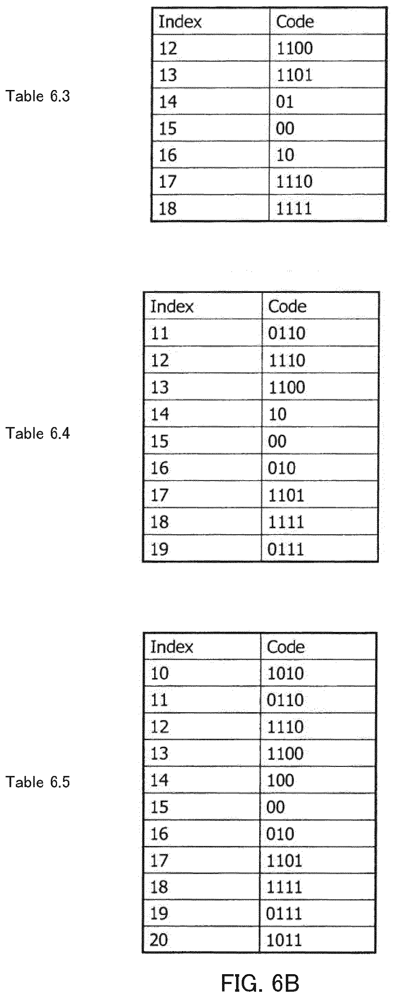

As example, a set of 4 predefined Huffman tables are shown in Figures 6A and 6B. In this example, there are 4 predefined Huffman tables, covered range of [13,17], [12,18],[11,19] and [10,20] correspondingly. Table 6.1 shows the flag signal and corresponding range for Huffman table. Table 6.2 shows the Huffman codes for all the values in the range of [13,17]. Table 6.3 shows the Huffman codes for all the values in the range of [12,18]. Table 6.4 shows the Huffman codes for all the values in the range of [11,19]. Table 6.5 shows the Huffman codes for all the values in the range of [10,20].

Comparing the Huffman code length in Figures 6A and 6B with the original Huffman table shown in Figure 4, it can be seen that the Huffman code length for the same values consumes fewer bits. It explains how the bits are saved.

In the decoder illustrated in Figure 5, according to the flag signal, the corresponding Huffman table is selected (507) for decoding of the differential indices (508). The differential indices are used to reconstruct the norm factors quantization indices according to the equation below:
$\begin{matrix}Diff _ index \left(n\right) = Index \left(n\right) + Index \left(n-1\right) - 15 \\ for n ∈ \left[1, 43\right]\end{matrix}$ (Equation 4)

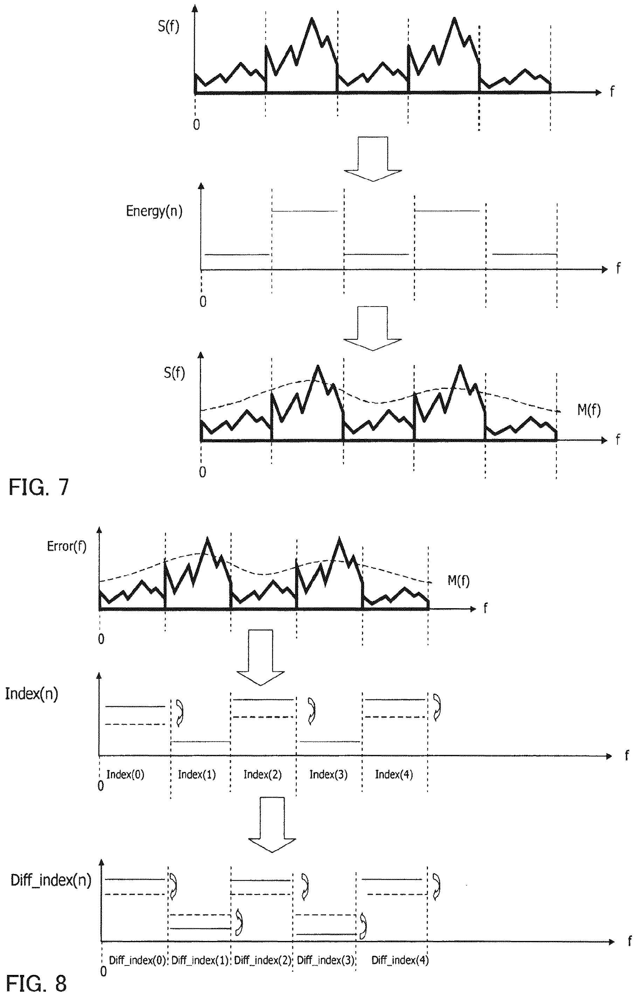

Figure 7 illustrates the derivation of the masking curve of the input signal. Firstly, the energies of the sub bands are calculated, and with these energies and masking curve of the input signal are derived. The masking curve derivation can utilize some prior art existing technologies such as the masking curve derivation method in MPEG AAC codec.

Figure 8 illustrates how the range of the differential indices is narrowed down. Firstly, the comparison is done between the masking threshold and the sub band quantization error energy. For the sub bands whose quantization errors energy are below the masking threshold, their indices are modified to a value which is closer to the neighbouring sub band, but the modification is ensured that the corresponding quantization error energy does not exceed the masking threshold, so that sound quality is not affected. After the modification, the range of the indices can be narrowed down. It is explained as below.

As shown in figure 8, for sub bands 0, 2 and 4, because their quantization error energies are below the masking threshold, their indices are modified to be closer to their neighbouring indices.

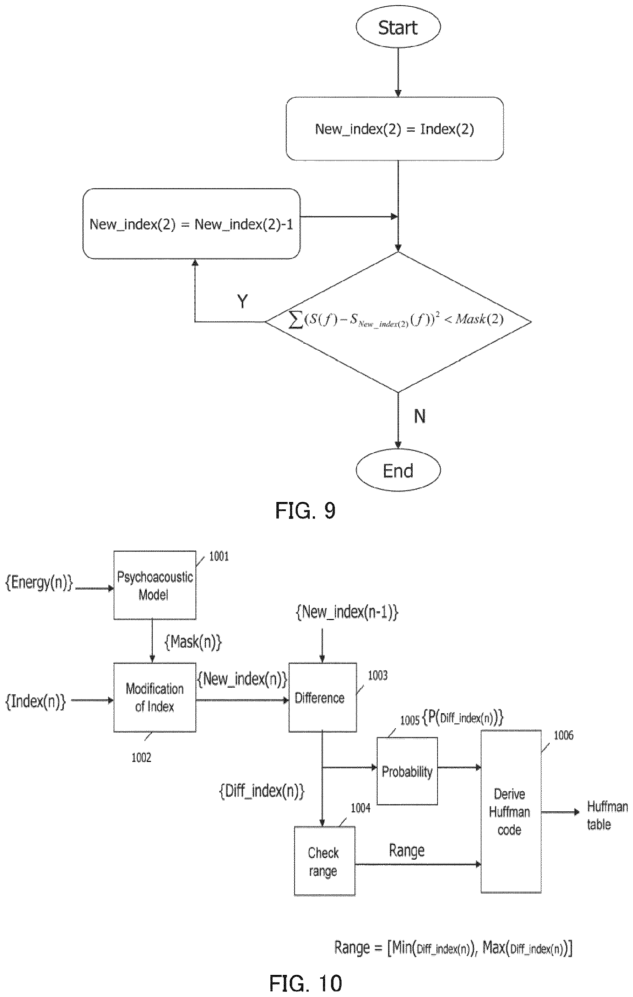

The modification of the indices can be done as below (using sub band 2 as example). As shown in Figure 2, large index is corresponding to smaller energy, and then Index(1) is smaller than Index(2). The modification of Index(2) is actually to decrease its value. It can be done as shown in Figure 9.

For sub bands 1 and 3, because their energies are above the masking threshold, their indices are not changed. Then the differential indices are closer to the centre. Using sub band 1 as example:
[5] $Diff _ index \left(1\right) = Index \left(1\right) - Index \left(0\right) + 15 for n ∈ \left[1, 43\right]$ (Equation 5)
[6] $\begin{matrix}New _ diff _ index \left(1\right) = New _ Index \left(1\right) - New _ Index \left(0\right) + 15 \\ for n ∈ \left[1, 43\right]\end{matrix}$ (Equation 6)
[7] $\begin{matrix}∵ New _ index \left(1\right) - New _ index \left(0\right) < Index \left(1\right) - Index \left(0\right) \\ ∴ New _ diff _ index \left(1\right) - 15 < Diff _ index \left(1\right) - 15\end{matrix}$ (Equation 7)

In this invention, the design of the Huffman table can be done offline with a large input sequence database. The process is illustrated in Figure 10.

The energies of the sub bands processed by the psychoacoustic modelling (1001) to derive the masked threshold Mask(n). According to the derived Mask(n), the quantization indices of the norm factors for the sub bands whose quantization errors energy are below the masking threshold are modified (1002) so that the range of the differential indices can be smaller.

The differential indices for the modified indices are calculated (1003).

The range of the differential indices for Huffman coding is identified (1004). For each value of range, all the input signal which have the same range will be gathered and the probability distribution of each value of the differential index within the range is calculated.

For each value of range, one Huffman table is designed according to the probability. Some traditional Huffman table design methods can be used here to design the Huffman table.

### (Embodiment 2)

In this embodiment, a method which can maintain the bits saving, but to restore the differential indices to a value closer to the original value is introduced.

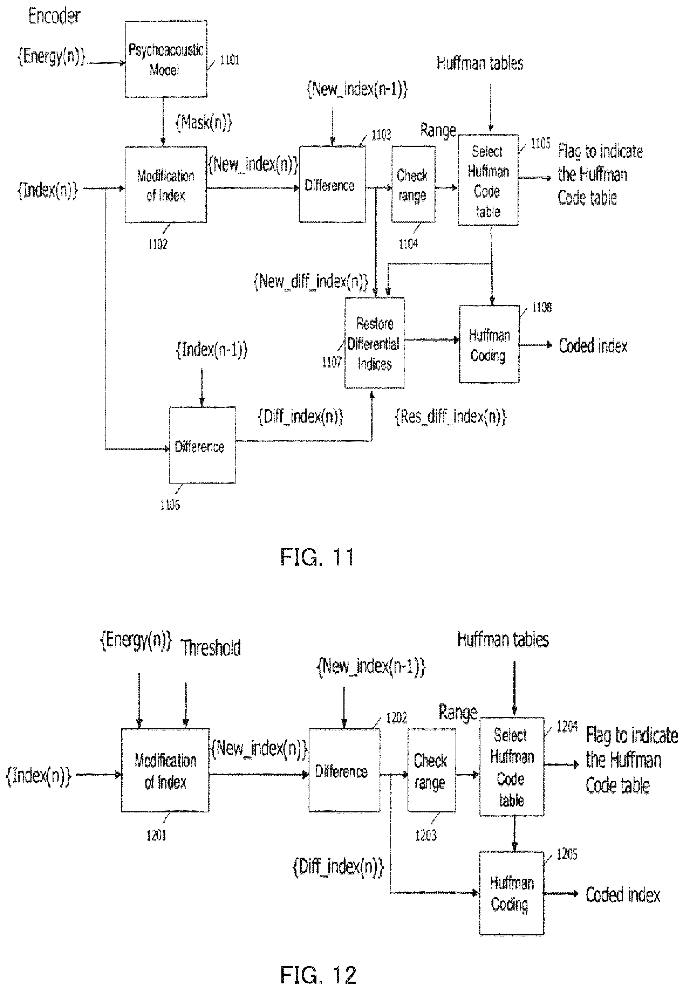

As shown in figure 11, after the Huffman table is selected in 1105, the differential indices are calculated between the original quantization indices. The original differential indices and new differential indices are compared whether they consume same bits in the selected Huffman table.

If they consume same number of bits in the selected Huffman table, the modified differential indices are restored to the original differential indices. If they don't consume same number of bits, the code words in the Huffman table which is closest to the original differential indices and consumes same number of bits are selected as the restored differential indices.

The merits of this embodiment are quantization error of the norm factor can be smaller while the bits consumption is the same as the embodiment 1.

### (Embodiment 3)

**In** this embodiment, a method which avoids using of the psychoacoustic model but only use some energy ratio threshold is introduced.

As shown in figure 12, instead of using the psychoacoustic model to derive the masking threshold. The energies of the sub bands and a predefined energy ratio threshold are used to determine whether to modify the quantization index of the specific sub band

(1201). As shown in the equation below, if the energy ratio between current sub band and neighbouring sub band is less than threshold, then current sub band is considered as not so important, then the quantization index of the current sub band can be modified.$\begin{matrix}Energy \left(n\right) / Energy \left(n-1\right) < Threshold \\ & & Energy \left(n\right) / Energy \left(n+1\right) < Threshold\end{matrix}$ (Equation 8)

The modification of the quantization index can be done as shown in the equation below:
$\begin{matrix}{\left(\frac{{NF}_{New _ index \left(n\right)}}{{NF}_{Index \left(n\right)}}\right)}^{2} = Min \left(Energy\left(n-1\right),Energy\left(n+1\right)\right) * Threshold / Energy \left(n\right) \\ ⇒ {NF}_{New _ index \left(n\right)} = \sqrt{Min \left(Energy\left(n-1\right),Energy\left(n+1\right)\right) * Threshold / Energy \left(n\right)} * {NF}_{Index \left(n\right)}\end{matrix}$ (Equation 9) where,
*NF*_{*New_index*(*n*)} means the decoded norm factor for sub band n using modified quantization index
*NF*_{*Index*(*n*)} means the decoded norm factor for sub band nusing the original quantization index
*Energy*(*n* - 1) means the energy for sub band n -1
*Energy(n)* means the energy for sub band n
*Energy(n* + 1) means the energy for sub band n + 1

The merit of this embodiment is the very complex and high complexity psychoacoustic modelling can be avoided.
The claims are directed towards the implementations described in the following. The remaining implementations are for explanatory purpose only.

### (Embodiment 4)

In this embodiment, a method which narrows down the range of the differential indices while being able to perfectly reconstruct the differential indices is introduced.

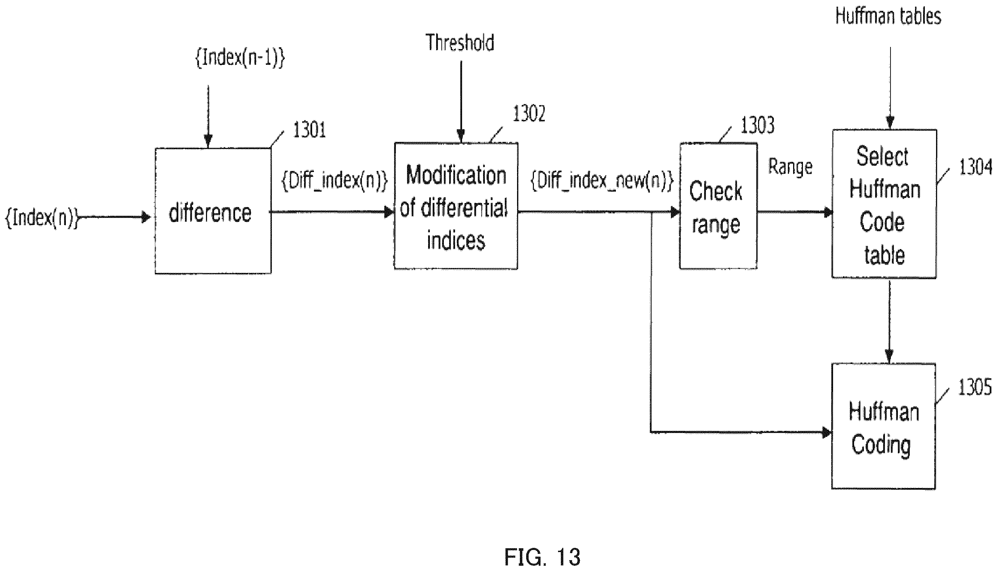

As shown in figure 13, the differential indices are derived from the original quantization indices (1301) according to the equation below:
$Diff _ index \left(n\right) = Index \left(n\right) - Index \left(n-1\right) + 15$ (Equation 10) where,
*Diff_index(n)* means differential index for sub band n
*Index(n)* means the quantization index for sub band n
*Index(n -1)* means the quantization index for sub band n -1

In order to reduce the range of the differential indices, a module is implemented to modify values of some differential indices (1302).

The modification is done according to the value of the differential index for the preceding sub band and a threshold.

One way to modify the differential index (when n ≥ 1) can be done as shown in the equation below, the first differential index would not be modified so as to achieve perfect reconstruction in decoder side:
$\begin{matrix}if Diff _ index \left(n-1\right) > \left(15+Threshold\right) , \\ Diff _ inde x _ new \left(n\right) = Diff _ index \left(n\right) + Diff _ index \left(n-1\right) - \left(15+Threshold\right) ; \\ else if Diff _ index \left(n-1\right) < \left(15-Threshold\right) , \\ Diff _ index _ new \left(n\right) = Diff _ index \left(n\right) + Diff _ index \left(n-1\right) - \left(15-Threshold\right) ; \\ otherwise \\ Diff _ inde x _ new \left(n\right) = Diff _ index \left(n\right) ;\end{matrix}$ (Equation 11) where,
n ≥ 1;
*Diff index* (n) means differential index for sub band n;
*Diff index (n* -1) means differential index for sub band n - 1;
*Diff index _new* (n) means the new differential index for sub band n;
*Threshold* means the value to examine whether to make the modification of the differential index

The reason why this modification can reduce the range of the differential indices is explained as following: for audio/speech signal, it is true that the energy fluctuates from one frequency band to another frequency band. However, it is observed that, there is normally no abrupt change in energy from neighboring frequency bands. The energy gradually increases or decreases from one frequency band to another frequency band. The norm factors which represent the energy also gradually changes. The norm factor quantization indices would also gradually change, and then the differential indices would vary in a small range.

The abrupt energy change happens only when some main sound components which have large energy start to show effect in the frequency band or their effect start to diminish. The norm factors which represent the energy also have abrupt change from the preceding frequency band, the norm factor quantization indices would also suddenly increase or decrease by a large value. Then it resulted in a very large or very small differential index.

As an example, assume that there is one main sound component which has large energy in frequency sub band n. While in frequency sub band (n-1) and (n+1), there is no main sound component. Then according to the Huffman table in Figure 2, Index (n) will have very small value, while Index (n-1) and Index (n+1) will have very large value. Then according to Equation (10), Diff_index(n) is very small (less than (15-Threshold)) and Diff_index(n+1) is very large. If the modification in Equation (11) is conducted, then according to Equation (12) below, the upper boundary of the differential indices can be possibly reduced, therefore the range of the differential indices can be narrowed down.$\begin{matrix}∵ Diff _ index _ new \left(n-1\right) < \left(15-Threshold\right) \\ ∴ Diff _ index \left(n-1\right) - \left(15-Threshold\right) < 0 \\ ∵ Diff _ index _ new \left(n\right) = Diff _ index \left(n\right) + Diff _ index \left(n-1\right) - \left(15-Threshold\right) ; \\ ∴ Diff _ index _ new \left(n\right) < Diff _ index \left(n\right)\end{matrix}$ (Equation 12)

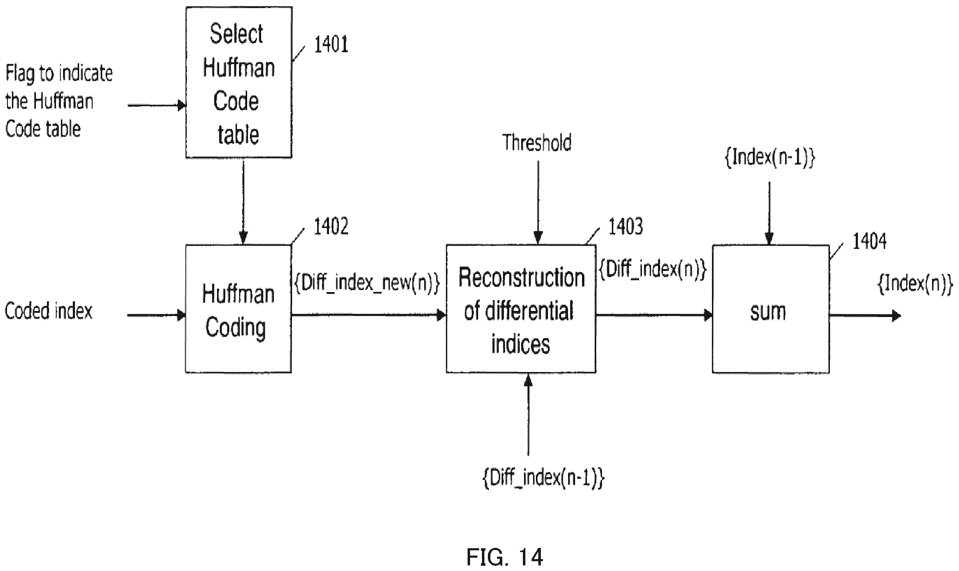

As shown in Figure 14, in decoder side, in order to perfectly reconstruct the differential indices, one module named as 'reconstruction of differential indices' (1403) is implemented. The reconstruction is done according to the value of the differential index for the preceding sub band and a threshold. The threshold in decoder is same as the threshold used in encoder.

The way to reconstruct the differential index(when n ≥ 1), which is corresponding to the modification in encoder, can be done as shown in the equation below, the first differential index would be directly received as it is not modified at encoder side:
$\begin{matrix}if Diff _ index \left(n-1\right) > \left(15+Threshold\right) , \\ Diff _ index \left(n\right) = Diff _ index _ new \left(n\right) - Diff _ index \left(n-1\right) + \left(15+Threshold\right) ; \\ else if Diff _ index \left(n-1\right) < \left(15-Threshold\right) , \\ Diff _ index \left(n\right) = Diff _ index _ new \left(n\right) - Diff _ index \left(n-1\right) + \left(15-Threshold\right) ; \\ otherwise \\ Diff _ index \left(n\right) = Diff _ index _ new \left(n\right) ;\end{matrix}$ (Equation 13) where,
n ≥ 1;
*Diff_index(n)* means differential index for sub band n;
*Diff_index*(n -1) means differential index for sub band n -1;
*Diff_index _new*(n) means the new differential index for sub band n;
*Threshold* means the value to examine whether to reconstruct the differential index;

As shown in the above Equation (11) and Equation (13), whether the modification of a differential index should be done and how much it should be modified is all dependent on the differential index for preceding frequency band. If the differential index for the preceding frequency band can be perfectly reconstructed, then the current differential index can also be perfectly reconstructed.

As shown in the above Equation (11) and Equation (13), the first differential index is not modified at encoder side, it is directly received and can be perfectly reconstructed, then the second differential index can be reconstructed according to the value of the first differential index; then the third differential index, the forth differential index, and so on, by following the same procedure, all the differential indices can be perfectly reconstructed.

The merit of this embodiment is that the range of the differential indices can be reduced, while the differential indices can still be perfectly reconstructed in decoder side. Therefore, the bits efficiency can be improved while retain the bit exactness of the quantization indices.

Further, although cases have been described with the embodiments above where the present invention is configured by hardware, the present invention may be implemented by software in combination with hardware.

Each function block employed in the description of the aforementioned embodiment may typically be implemented as an LSI constituted by an integrated circuit. These may be individual chips or partially or entirely contained on a single chip. "LSI" is adopted here but this may also be referred to as "IC," "system LSI," "super LSI" or "ultra LSI" depending on differing extents of integration.

Further, the method of circuit integration is not limited to LSI's, and implementation using dedicated circuitry or general purpose processors is also possible. After LSI manufacture, utilization of an FPGA (Field Programmable Gate Array) or a reconfigurable processor where connections and settings of circuit cells within an LSI can be reconfigured is also possible.

Further, if integrated circuit technology comes out to replace LSI's as a result of the advancement of semiconductor technology or a derivative other technology, it is naturally also possible to carry out function block integration using this technology. Application of biotechnology is also possible.

### Industrial Applicability

The encoding apparatus, decoding apparatus and encoding and decoding methods according to the present invention are applicable to a wireless communication terminal apparatus, base station apparatus in a mobile communication system, tele-conference terminal apparatus, video conference terminal apparatus and voice over internet protocol (VOIP) terminal apparatus.

### Reference Notations List

- 101: Transient detector
- 102: Transform
- 103: Norm estimation
- 104: Norm quantization and coding
- 105: Spectrum normalization
- 106: Norm adjustment
- 107: Bit allocation
- 108: Lattice quantization and coding
- 109: Noise level adjustment
- 110: Multiplex
- 111: Demultiplex
- 112: Lattice decoding
- 113: Spectral fill generator
- 114: Envelope shaping
- 115: Inverse transform
- 301: Scalar Quantization (32 steps)
- 302: Scalar Quantization (40 steps)
- 303: Direct Transmission (5 bits)
- 304: Difference
- 305: Fixed length coding
- 306: Huffman coding
- 501: Psychoacoustic model
- 502: Modification of index
- 503: Difference
- 504: Check range
- 505: Select Huffman code table
- 506: Huffman coding
- 507: Select Huffman table
- 508: Huffman decoding
- 509: Sum
- 1001: Psychoacoustic model
- 1002: Modification of index
- 1003: Difference
- 1004: Check range
- 1005: Probability
- 1006: Derive Huffman code
- 1101: Psychoacoustic model
- 1102: Modification of index
- 1103: Difference
- 1104: Check range
- 1105: Select Huffman code table
- 1106: Difference
- 1107: Restore differential indices
- 1108: Huffman coding
- 1201: Modification of index
- 1202: Difference
- 1203: Check range
- 1204: Select Huffman code table
- 1205: Huffman coding
- 1301: Difference
- 1302: Modification of differential indices
- 1303: Check range
- 1304: Select Huffman code table
- 1305: Huffman coding
- 1401: Select Huffman code table
- 1402: Huffman coding
- 1403: Reconstruction of differential indices
- 1404: Sum

## Claims

1. An audio/speech encoding apparatus for encoding an input audio/speech signal, the audio/speech encoding apparatus comprising:
a differential index calculation section (1301) configured to calculate a differential index for each of a plurality of bands from quantization indices for neighboring frequency subbands of a frequency spectrum of the input audio/speech signal, wherein the differential index is calculated by adding an offset value to a difference of adjacent quantization indices for the neighboring frequency subbands;
a modification section (1302) configured to modify a range of differential indices by replacing an original Nth differential index with a new Nth differential index, N being an integer equals to or larger than 2, if an original (N-1)th differential index is larger than a first value or smaller than a second value that is smaller than the first value, wherein an original first differential index is not modified, wherein the first value is obtained by adding a threshold value to the offset value and the second value is obtained by subtracting the threshold value from the offset value;
a Huffman coding section (1305) configured to encode the original first differential index and the differential indices after the modification using a Huffman table which is selected from a plurality of predefined Huffman tables; and
a transmitter configured to transmit a flag signal that indicates the selected Huffman table.

2. The audio/speech encoding apparatus according to claim 1, wherein
if the original (N-1)th differential index is larger than the first value, the original Nth differential index is replaced with the new Nth differential index by adding a value obtained by subtracting the first value from the original (N-1) differential index; and
if the original (N-1)th differential index is smaller than the second value, the original Nth differential index is replaced with the new Nth differential index by adding a value obtained by subtracting the second value from the original (N-1)th differential index.

3. The audio/speech encoding apparatus according to claim 1, wherein
if the original (N-1)th differential index lies within a range between the first value and the second value, the original Nth differential index is not modified.

4. The audio/speech encoding apparatus according to claim 1, wherein
the offset value is fifteen and the threshold value is a value for determining whether to modify each of the differential indices or not;.

5. The audio/speech encoding apparatus according to claim 1, wherein
the transmitter configured to transmit the Huffman coded original first differential index and the Huffman coded differential indices.

6. An audio/speech encoding method for encoding an input audio/speech signal, the audio/speech encoding method comprising:
calculating a differential index for each of a plurality of bands from quantization indices for neighboring frequency subbands of a frequency spectrum of the input audio/speech signal, wherein the differential index is calculated by adding an offset value to a difference of adjacent quantization indices for the neighboring frequency subbands;
modifying a range of differential indices by replacing an original Nth differential index with a new Nth differential index, N being an integer equals to or larger than 2, if an original (N-1)th differential index is larger than a first value or smaller than a second value that is smaller than the first value, wherein an original first differential index is not modified, wherein the first value is obtained by adding a threshold value to the offset value and the second value is obtained by subtracting the threshold value from the offset value;
encoding the original first differential index and the differential indices after the modification using a Huffman table, which is selected from a plurality of predefined Huffman tables; and
a transmitter configured to transmit a flag signal that indicates the selected Huffman table.

7. The audio/speech encoding method according to claim 6, wherein
if the original (N-1)th differential index is larger than the first value, the original Nth differential index is replaced with the new Nth differential index by adding a value obtained by subtracting the first value from the original (N-1) differential index; and
if the original (N-1)th differential index is smaller than the second value, the original Nth differential index is replaced with the new Nth differential index by adding a value obtained by subtracting the second value from the original (N-1)th differential index.

8. The audio/speech encoding method according to claim 6, wherein
if the original (N-1)th differential index lies within a range between the first value and the second value, the original Nth differential index is not modified.

9. The audio/speech encoding method according to claim 6, wherein
the differential index is calculated by adding an offset value to a difference of the adjacent quantization indices;
the first value is obtained by adding a threshold value to the offset value, wherein the threshold value is a value for determining whether to modify each of the differential indices or not; and
the second value is obtained by subtracting the threshold value from the offset value.

10. The audio/speech encoding method according to claim 6, the audio/speech encoding method further comprising:
transmitting the Huffman coded original first differential index and the Huffman coded differential indices, wherein the Huffman table is selected from a plurality of Huffman tables.

## Patentansprüche

1. Audio/Sprache-Codiervorrichtung für das Codieren eines eingegebenen Audio/Sprache-Signals, wobei die Audio/Sprache-Codiervorrichtung umfasst:
einen Differenzindex-Berechnungsabschnitt (1301), der konfiguriert ist zum Berechnen eines Differenzindex für jedes aus einer Vielzahl von Bändern aus Quantisierungsindizes für benachbarte Frequenzsubbänder eines Frequenzspektrums des eingegebenen Audio/Sprache-Signals, wobei der Differenzindex durch das Addieren eines Versatzwerts zu einer Differenz von benachbarten Quantisierungsindizes für die benachbarten Frequenzsubbänder berechnet wird,
einen Modifikationsabschnitt (1302), der konfiguriert ist zum Modifizieren eines Bereichs von Differenzindizes durch das Ersetzen eines ursprünglichen N-ten Differenzindex durch einen neuen N-ten Differenzindex, wobei N eine Ganzzahl gleich oder größer als 2 ist, wenn ein ursprünglicher (N-1)-ter Differenzindex größer als ein erster Wert oder kleiner als ein zweiter Wert, der kleiner als der erste Wert ist, ist, wobei ein ursprünglicher erster Differenzindex nicht modifiziert wird, wobei der erste Wert durch das Addieren eines Schwellenwerts zu dem Versatzwert erhalten wird und der zweite Wert durch das Subtrahieren des Schwellenwerts von dem Versatzwert erhalten wird,
einen Huffman-Codierabschnitt (1305), der konfiguriert ist zum Codieren des ursprünglichen ersten Differenzindex und der Differenzindizes nach der Modifikation unter Verwendung einer Huffman-Tabelle, die aus einer Vielzahl von vordefinierten Huffman-Tabellen ausgewählt wird, und
einen Sender, der konfiguriert ist zum Senden eines Flag-Signals, das die ausgewählte Huffman-Tabelle angibt.

2. Audio/Sprache-Codiervorrichtung nach Anspruch 1, wobei:
wenn der ursprüngliche (N-1)-te Differenzindex größer als der erste Wert ist, der ursprüngliche N-te Differenzindex durch den neuen N-ten Differenzindex ersetzt wird, indem ein durch das Subtrahieren des ersten Werts von dem ursprünglichen (N-1)-ten Differenzindex erhaltener Wert addiert wird, und
wenn der ursprüngliche (N-1)-te Differenzindex kleiner als der zweite Wert ist, der ursprüngliche N-te Differenzindex durch den neuen N-ten Differenzindex ersetzt wird, indem ein durch das Subtrahieren des zweiten Werts von dem ursprünglichen (N-1)-ten Differenzindex erhaltener Wert addiert wird.

3. Audio/Sprache-Codiervorrichtung nach Anspruch 1, wobei:
wenn der ursprüngliche (N-1)-te Differenzindex in einem Bereich zwischen dem ersten Wert und dem zweiten Wert liegt, der ursprüngliche N-te Differenzindex nicht modifiziert wird.

4. Audio/Sprache-Codiervorrichtung nach Anspruch 1, wobei:
der Versatzwert fünfzehn beträgt und der Schwellenwert ein Wert für das Bestimmen, ob jeder der Differenzindizes modifiziert werden soll oder nicht, ist.

5. Audio/Sprache-Codiervorrichtung nach Anspruch 1, wobei:
der Sender konfiguriert ist zum Senden des Huffman-codierten ursprünglichen ersten Differenzindex und der Huffman-codierten Differenzindizes.

6. Audio/Sprache-Codierverfahren zum Codieren eines eingebebenen Audio/Sprache-Signals, wobei das Audio/Sprache-Codierverfahren aufweist:
Berechnen eines Differenzindex für jedes aus einer Vielzahl von Bändern aus Quantisierungsindizes für benachbarte Frequenzsubbänder eines Frequenzspektrums des eingegebenen Audio/Sprache-Signals, wobei der Differenzindex durch das Addieren eines Versatzwerts zu einer Differenz von benachbarten Quantisierungsindizes für die benachbarten Frequenzsubbänder berechnet wird,
Modifizieren eines Bereichs von Differenzindizes durch das Ersetzen eines ursprünglichen N-ten Differenzindex durch einen neuen N-ten Differenzindex, wobei N eine Ganzzahl gleich oder größer als 2 ist, wenn ein ursprünglicher (N-1)-ter Differenzindex größer als ein erster Wert oder kleiner als ein zweiter Wert, der kleiner als der erste Wert ist, ist, wobei ein ursprünglicher erster Differenzindex nicht modifiziert wird, wobei der erste Wert durch das Addieren eines Schwellenwerts zu dem Versatzwert erhalten wird und der zweite Wert durch das Subtrahieren des Schwellenwerts von dem Versatzwert erhalten wird,
Codieren des ursprünglichen ersten Differenzindex und der Differenzindizes nach der Modifikation unter Verwendung einer Huffman-Tabelle, die aus einer Vielzahl von vordefinierten Huffman-Tabellen ausgewählt wird, und
einen Sender, der konfiguriert ist zum Senden eines Flag-Signals, das die ausgewählte Huffman-Tabelle angibt.

7. Audio/Sprache-Codierverfahren nach Anspruch 6, wobei:
wenn der ursprüngliche (N-1)-te Differenzindex größer als der erste Wert ist, der ursprüngliche N-te Differenzindex durch den neuen N-ten Differenzindex ersetzt wird, indem ein durch das Subtrahieren des ersten Werts von dem ursprünglichen (N-1)-ten Differenzindex erhaltener Wert addiert wird, und
wenn der ursprüngliche (N-1)-te Differenzindex kleiner als der zweite Wert ist, der ursprüngliche N-te Differenzindex durch den neuen N-ten Differenzindex ersetzt wird, indem ein durch das Subtrahieren des zweiten Werts von dem ursprünglichen (N-1)-ten Differenzindex erhaltener Wert addiert wird.

8. Audio/Sprache-Codierverfahren nach Anspruch 6, wobei:
wenn der ursprüngliche (N-1)-te Differenzindex in einem Bereich zwischen dem ersten Wert und dem zweiten Wert liegt, der ursprüngliche N-te Differenzindex nicht modifiziert wird.

9. Audio/Sprache-Codierverfahren nach Anspruch 6, wobei:
der Differenzindex durch das Addieren eines Versatzwerts zu einer Differenz der benachbarten Quantisierungsindizes berechnet wird,
der erste Wert durch das Addieren eines Schwellenwerts zu dem Versatzwert erhalten wird, wobei der Schwellenwert ein Wert für das Bestimmen, ob jeder der Differenzindizes modifiziert werden soll oder nicht, ist, und
der zweite Wert durch das Subtrahieren des Schwellenwerts von dem Versatzwert erhalten wird.

10. Audio/Sprache-Codierverfahren nach Anspruch 6, wobei das Audio/Sprache-Codierverfahren weiterhin aufweist:
Senden des Huffman-codierten ursprünglichen ersten Differenzindex und der Huffman-codierten Differenzindizes, wobei die Huffman-Tabelle aus einer Vielzahl von Huffman-Tabellen ausgewählt wird.

## Revendications

1. Appareil de codage audio/vocal pour coder un signal audio/vocal d'entrée, l'appareil de codage audio/vocal comprenant :
une section de calcul d'indice différentiel (1301) configurée pour calculer un indice différentiel pour chacune d'une pluralité de bandes à partir d'indices de quantification pour des sous-bandes de fréquences voisines d'un spectre de fréquences du signal audio/vocal d'entrée, dans lequel l'indice différentiel est calculé en ajoutant une valeur de décalage à une différence d'indices de quantification adjacents pour les sous-bandes de fréquences voisines ;
une section de modification (1302) configurée pour modifier une plage d'indices différentiels en remplaçant un N^{ième} indice différentiel d'origine par un nouveau N^{ième} indice différentiel, N étant un entier égal ou supérieur à 2, si un (N-1)^{ième} indice différentiel d'origine est supérieur à une première valeur ou inférieur à une seconde valeur qui est inférieure à la première valeur, dans lequel un premier indice différentiel d'origine n'est pas modifié, dans lequel la première valeur est obtenue en ajoutant une valeur de seuil à la valeur de décalage et la seconde valeur est obtenue en soustrayant la valeur de seuil de la valeur de décalage ;
une section de codage de Huffman (1305) configurée pour coder le premier indice différentiel d'origine et les indices différentiels après la modification en utilisant une table de Huffman qui est sélectionnée parmi une pluralité de tables de Huffman prédéfinies ; et
un émetteur configuré pour transmettre un signal indicateur qui indique la table de Huffman sélectionnée.

2. Appareil de codage audio/vocal selon la revendication 1, dans lequel
si le (N-1)^{ième} indice différentiel d'origine est supérieur à la première valeur, le N^{ième} indice différentiel d'origine est remplacé par le nouveau N^{ième} indice différentiel en ajoutant une valeur obtenue en soustrayant la première valeur à partir du (N-1)^{ième} indice différentiel d'origine ; et
si le (N-1)^{ième} indice différentiel d'origine est inférieur à la seconde valeur, le N^{ième} indice différentiel d'origine est remplacé par le nouveau N^{ième} indice différentiel en ajoutant une valeur obtenue en soustrayant la seconde valeur à partir du (N-1)^{ième} indice différentiel d'origine.

3. Appareil de codage audio/vocal selon la revendication 1, dans lequel si le (N-1)^{ième} indice différentiel d'origine se situe dans une plage entre la première valeur et la seconde valeur, le N^{ième} indice différentiel d'origine n'est pas modifié.

4. Appareil de codage audio/vocal selon la revendication 1, dans lequel la valeur de décalage est de quinze et la valeur de seuil est une valeur permettant de déterminer s'il faut modifier chacun des indices différentiels ou non.

5. Appareil de codage audio/vocal selon la revendication 1, dans lequel l'émetteur étant configuré pour transmettre le premier indice différentiel d'origine à codage de Huffman et les indices différentiels à codage de Huffman.

6. Procédé de codage audio/vocal pour coder un signal audio/vocal d'entrée, le procédé de codage audio/vocal comprenant les étapes consistant à :
calculer un indice différentiel pour chacune d'une pluralité de bandes à partir d'indices de quantification pour des sous-bandes de fréquences voisines d'un spectre de fréquences du signal audio/vocal d'entrée, dans lequel l'indice différentiel est calculé en ajoutant une valeur de décalage à une différence d'indices de quantification adjacents pour les sous-bandes de fréquences voisines ;
modifier une plage d'indices différentiels en remplaçant un N^{ième} indice différentiel d'origine par un nouveau N^{ième} indice différentiel, N étant un entier égal ou supérieur à 2, si un (N-1)^{ième} indice différentiel d'origine est supérieur à une première valeur ou inférieur à une seconde valeur qui est inférieure à la première valeur, dans lequel un premier indice différentiel d'origine n'est pas modifié, dans lequel la première valeur est obtenue en ajoutant une valeur de seuil à la valeur de décalage et la seconde valeur est obtenue en soustrayant la valeur de seuil de la valeur de décalage ;
coder le premier indice différentiel d'origine et les indices différentiels après la modification en utilisant une table de Huffman , qui est sélectionnée parmi une pluralité de tables de Huffman prédéfinies ; et
un émetteur configuré pour transmettre un signal indicateur qui indique la table de Huffman sélectionnée.

7. Appareil de codage audio/vocal selon la revendication 6, dans lequel
si le (N-1)^{ième} indice différentiel d'origine est supérieur à la première valeur, le N^{ième} indice différentiel d'origine est remplacé par le nouveau N^{ième} indice différentiel en ajoutant une valeur obtenue en soustrayant la première valeur à partir du (N-1)^{ième} indice différentiel d'origine ; et
si le (N-1)^{ième} indice différentiel d'origine est inférieur à la seconde valeur, le N^{ième} indice différentiel d'origine est remplacé par le nouveau N^{ième} indice différentiel en ajoutant une valeur obtenue en soustrayant la seconde valeur à partir du (N-1)^{ième} indice différentiel d'origine.

8. Appareil de codage audio/vocal selon la revendication 6, dans lequel si le (N-1)^{ième} indice différentiel d'origine se situe dans une plage entre la première valeur et la seconde valeur, le N^{ième} indice différentiel d'origine n'est pas modifié.

9. Appareil de codage audio/vocal selon la revendication 6, dans lequel l'indice différentiel est calculé en ajoutant une valeur de décalage à une différence des indices de quantification adjacents ;
la première valeur est obtenue en ajoutant une valeur de seuil à la valeur de décalage, dans lequel la valeur de seuil est une valeur permettant de déterminer s'il faut modifier ou non chacun des indices différentiels ; et
la seconde valeur est obtenue en soustrayant la valeur de seuil à partir de la valeur de décalage.

10. Procédé de codage audio/vocal selon la revendication 6, le procédé de codage audio/vocal comprenant en outre l'étape consistant à :
transmettre le premier indice différentiel d'origine à codage de Huffman et les indices différentiels à codage de Huffman, dans lequel la table de Huffman est sélectionnée parmi une pluralité de tables de Huffman.
